# EUROPÄISCHE PATENTSCHRIFT

(11) **EP 3 021 356 B1**
(45) Veröffentlichungstag und Bekanntmachung des Hinweises auf die Patenterteilung: **21.06.2017**
(21) Anmeldenummer: 15190955.3
(22) Anmeldetag: 22.10.2015
(51) Int. Cl.: H01L 23/49, B32B 15/01

(54) **VERBINDUNGSANORDNUNG MIT EINEM MEHRSCHICHTIGEN BONDFLACHDRAHT**
CONNECTION ARRANGEMENT WITH A MULTILAYER RIBBON BOND WIRE
AGENCEMENT DE CONNEXION AVEC UN FILS DE CONNEXION RUBAN MULTICOUCHE

(30) Priorität: 17.11.2014 DE 102014223352
(43) Veröffentlichungstag der Anmeldung: 18.05.2016
(73) Patentinhaber: ROBERT BOSCH GMBH, 70442 Stuttgart (DE)
(72) Erfinder: Reinold, Manfred, 71701 Schwieberdingen (DE); Mueller, Immanuel, 72810 Gomaringen (DE); Minkenberg, Bernd, 72762 Reutlingen (DE); Erbe, Bjoern, 72555 Metzingen (DE)

(56) Entgegenhaltungen:
- WO-A1-2012/049893
- WO-A1-2012/053129
- JP-A- 2008 117 825
- JP-A- 2012 227 241
- JP-A- 2014 168 009
- US-A1- 2010 207 279
- US-A1- 2014 197 539

## Beschreibung

### Stand der Technik

Die Erfindung betrifft eine Verbindungsanordnung. Die Verbindungsanordnung umfasst einen Halbleiter, ein Substrat und wenigstens ein Metallband, insbesondere Bonddraht. Der Halbleiter weist einen elektrischen Anschluss auf, welcher mittels des Metallbandes mit dem Substrat ultraschallverschweißt ist, wobei das Metallband wenigstens zwei Metallschichten aus zueinander verschiedenen Metallen oder Metall-Legierungen aufweist.

Bei aus dem Stand der Technik bekannten Halbleitermodulen, bei denen ein Halbleiter, welcher mit einem Substrat verbunden ist, zeigt sich häufig das Problem, dass es zu einer Ablösung des Metallbandes zu einer den Halbleiter und das Substrat und das Metallband umgebenden Moldmasse kommen kann.

Aus der US 2004/0217 488 A1 ist eine Verbindungsanordnung bekannt, bei der ein Halbleiter mittels eines Metallbandes mit einem elektrischen Anschluss mittels Ultraschallschweißen verbunden ist. Das Metallband ist aus wenigstens zwei Metallschichten gebildet, wobei eine Schicht eine Aluminiumschicht ist und eine weitere mit der Aluminiumschicht verbundene Schicht eine Kupferschicht ist. Die Kupferschicht weist eine größere Dicke auf als die Aluminiumschicht.

Aus der WO 2012/049893 A1 ist ein silberplattiertes Stahlbondband zum Kontaktieren eines Halbleiters bekannt.

### Offenbarung der Erfindung

Erfindungsgemäß beträgt eine Dickenerstreckung der mit dem Anschluss verbundenen Metallschicht des Metallbandes die Hälfte einer Dickenerstreckung der mit der Metallschicht verbundenen weiteren Metallschicht der Metallschichten.

Dadurch kann vorteilhaft eine geringe Ausfallrate der Bondverbindung erzielt werden. Es wurde nämlich festgestellt, dass die in der US 2004 0217 488 A1 vorgeschlagene Schichtstärke der weiteren Metallschicht, mit dem Verhältnis 3:1, oder 4:1 zu der mit dem Halbleiter verschweißten Metallschicht, nachteilig zu Ablösen des Metallbandes von dem Halbleiter oder von dem Substrat führt. Weiter wurde festgestellt, dass bei Schichtdickenverhältnissen, bei denen die weitere Metallschicht mehr als ein Dreifaches einer Schichtdicke als die mit dem Halbleiter verbundene Metallschicht beträgt, in nachteiliger Weise einen Stresseintrag in den Halbleiter bewirken kann.

Vorteilhaft konnten mit dem zuvor genannten Schichtdickenverhältnis von 2:1, bei dem die weitere Metallschicht, welche mit der mit dem Halbleiter verbundenen Metallschicht des Metallbandes verbunden ist, die doppelte Dickenabmessung aufweist, als die mit dem Halbleiter verbundene Metallschicht, eine Ausfallrate um ein Fünffaches im Vergleich zu einem Schichtdickenverhältnis von größer als 3:1 für die vorgenannte Schichtanordnung erzielt werden.

Das Metallband, insbesondere der Bonddraht, ist bevorzugt ein Flachdraht, bei dem eine Querschnittsbreitenabmessung größer ist als eine Dickenabmessung.

Bevorzugt ist die weitere Metallschicht aus einem Metall mit einer größeren elektrischen Leitfähigkeit gebildet, als die Leitfähigkeit der Metallschicht, welche mit dem Halbleiter verbunden ist. So kann vorteilhaft in dem Metallband eine kleine elektrische Verlustleistung erzeugt werden, insoweit das Metallband im Vergleich zu einem Metallband aus nur einem Metall, insbesondere einem Aluminiummetallband, einen kleineren Gesamtwiderstand aufweist.

In einer bevorzugten Ausführungsform ist die mit dem Halbleiter verbundene Metallschicht eine aluminiumhaltige Schicht oder eine Aluminiumschicht. Bevorzugt ist die weitere Metallschicht eine kupferhaltige Schicht oder eine Kupferschicht. Vorteilhaft lässt sich die Aluminiumschicht des Metallbandes leicht mit dem Halbleiter, insbesondere einem elektrischen Anschluss des Halbleiters, welcher Aluminium aufweist, verbinden, ohne den Halbleiter durch Kraterbildung zu beschädigen. Die Kupferschicht bewirkt vorteilhaft, dass über das Metallband ein größerer elektrischer Strom fließen kann, als bei einem Metallband, welches bei gleichen Abmessungen, insbesondere einer Gesamtdickenabmessung, nur aus Aluminium gebildet ist.

In einer bevorzugten Ausführungsform weist das Metallband drei miteinander verbundene Metallschichten auf. Weiter bevorzugt weist eine äußere Metallschicht dieselbe Dickenerstreckung auf wie die mit dem Anschluss verschweißte Metallschicht. Weiter bevorzugt ist die äußere Metallschicht aus demselben Material oder einer aus einem Material mit demselben oder einem ähnlichen Wärmeausdehnungskoeffizienten gebildet, wie die mit dem Anschluss verschweißte Metallschicht. Bevorzugt ist die weitere Metallschicht, insbesondere Kupferschicht, zwischen der mit dem Anschluss verschweißten Metallschicht und der äußeren Metallschicht eingeschlossen. So kann vorteilhaft durch die äußere Metallschicht ein Bimetalleffekt kompensiert werden, welcher zwischen der weiteren Metallschicht, insbesondere der Kupferschicht, und der mit dem Anschluss verbundenen Metallschicht, insbesondere der Aluminiumschicht, entstehen kann. Bevorzugt ist die äußere Metallschicht mit dem Wärmeausdehnungskoeffizienten, welcher dem Wärmeausdehnungskoeffizienten der mit dem Anschluss verbundenen Metallschicht entspricht, durch eine Schicht umfassend Aluminium und/oder Magnesium gebildet. Dadurch kann eine gute zusätzliche Wärmeableitung und eine gute Kompensation des Bimetalleffekts erreicht werden. Durch die Schicht umfassend Magnesium und Aluminium kann vorteilhaft eine große Festigkeit des Metallbandes bewirkt werden.

Bevorzugt sind die Metallschichten - bevorzugt mittels Walzplattieren - miteinander stoffschlüssig verbunden. Die Metallschichten können so aufwandsgünstig miteinander stoffschlüssig verbunden werden.

Bevorzugt ist die äußere Metallschicht durch eine Metallschicht gebildet, welche einen Wärmeausdehnungskoeffizienten aufweist, welcher zwischen dem Wärmeausdehnungskoeffizienten der weiteren Metallschicht und der dem Wärmeausdehnungskoeffizienten der mit dem Anschluss verbundenen Metallschicht liegt.

Die äußere Metallschicht, welche einen Wärmeausdehnungskoeffizienten zwischen dem der weiteren Metallschicht, insbesondere der Kupferschicht, und der mit dem Anschluss verbundenen Metallschicht, insbesondere Aluminiumschicht aufweist, ist in einer bevorzugten Ausführungsform durch eine Silberschicht gebildet. Die Silberschicht bewirkt vorteilhaft eine zusätzliche Verbesserung der elektrischen Leitfähigkeit und eine Wärmeleitfähigkeit des Metallbandes, sodass von dem Halbleiter, insbesondere einem Halbleiterschalter, im Vergleich zu einem bloßen Aluminiumband als Metallband ein größerer Strom abgeführt werden kann, als auch eine größere Wärmeleistung über das Metallband an das Substrat abgeführt werden kann.

In einer bevorzugten Ausführungsform sind der Halbleiter und das Metallband, oder zusätzlich wenigstens ein Teil des Substrats, in eine Moldmasse eingebettet. So sind das Metallband und der Halbleiter vorteilhaft vor äußeren Umwelteinflüssen geschützt. Die Moldmasse weist bevorzugt Partikel, insbesondere Keramikpartikel auf.

Bevorzugt weist die Moldmasse einen Wärmeausdehungskoeffizient, auch CTE (CTE = Coefficient of Thermal Expansion) genannt auf, welcher dem von Kupfer entspricht oder nahe dem von Kupfer liegt. Dadurch kann im Falle eines zweischichtigen Bonddrahtes eine kleine oder keine CTE-Differenz zwischen dem CTE von der Kupferschicht des Metallbandes und dem CTE der Moldmasse gebildet sein.

Bevorzugt weist die Moldmasse einen Wärmeausdehungskoeffizient auf welcher zwischen dem Wärmeausdehnungskoefizienten von Aluminium und Kupfer liegt. Dadurch kann im Falle eines dreischichtigen Bonddrahtes, umfassend zwei Aluminiumschichten und eine eingeschlossene Kupferschicht, eine kleine oder CTE-Differenz zwischen dem CTE des Metallbandes und dem CTE der Moldmasse gebildet sein.

In einer bevorzugten Ausführungsform ist der Halbleiter ein Halbleiterschalter, insbesondere ein Transistor, bevorzugt ein Feldeffekttransistor. Der Feldeffekttransistor ist bevorzugt ein MOS-Feldeffekttransistor (MOS = Metal-Oxide-Semiconductor) oder ein MIS-Feldeffekttranistor (MIS = Metal-Insulator-Semiconductor).

Das Substrat ist bevorzugt durch ein Blechstück, insbesondere ein Kupferblechstück, gebildet. Das Blechstück ist bevorzugt durch ein formgeschnittenes oder formgestanztes Blechstück gebildet, mit dem wenigstens eine elektrische Verbindungsleitung gebildet ist. Das Substrat ist bevorzugt durch ein Stanzgitter, auch Lead-Frame genannt, gebildet.

In einer bevorzugten Ausführungsform ist das Substrat ein keramisches Substrat, umfassend wenigstens eine elektrisch isolierende Keramikschicht und wenigstens eine elektrisch leitfähige Schicht, insbesondere eine Kupferschicht. Die elektrisch isolierende Schicht, insbesondere Keramikschicht, ist bevorzugt eine Aluminiumoxidschicht.

Die mit der elektrisch isolierenden Schicht verbundene elektrisch leitfähige Schicht kann in einer anderen Ausführungsform durch eine Aluminiumschicht gebildet sein.

Das Substrat ist bevorzugt ein DBC-Substrat (DBC = Direct-Bonded-Copper), ein IMS-Substrat (IMS = Insulated-Metal-Substrate) oder ein HTTC-Substrat (HTCC = High-Temperature-Cofired-Ceramics) oder ein AMB-Substrat (AMB = Active-Metal-Brazed).

In einer bevorzugten Ausführungsform weist der Anschluss des Halbleiters eine aluminiumhaltige Metallschicht auf. Die aluminiumhaltige Metallschicht ist beispielsweise eine Legierung umfassend Aluminium und Kupfer oder eine reine Aluminiumschicht. Die Metallschicht des Anschlusses des Halbleiters ist in einer anderen Ausführungsform eine Legierungsschicht, umfassend Nickel, Palladium und Gold.

Die Erfindung wird nun im Folgenden anhand einer Figur und weiteren Ausführungsbeispielen beschrieben. Weitere vorteilhafte Ausführungsvarianten ergeben sich aus den in den abhängigen Ansprüchen und den zu der Figur beschriebenen Merkmalen.

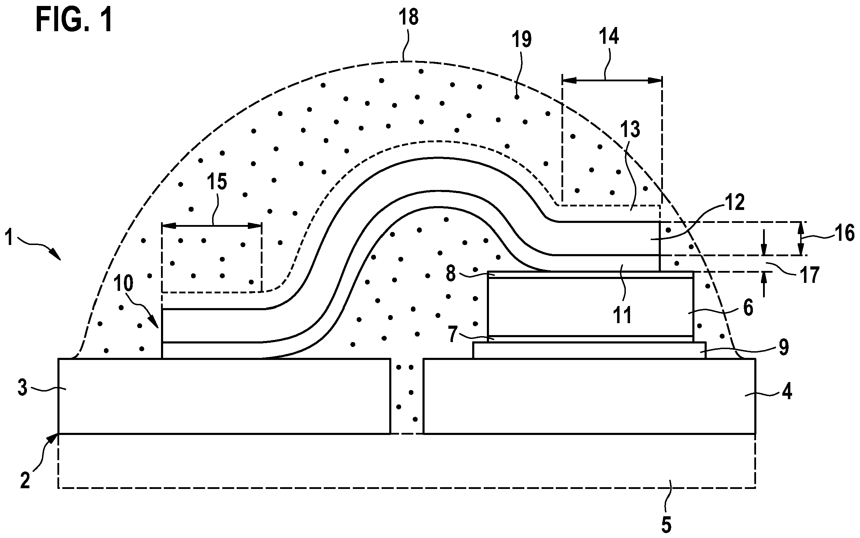

Figur 1 zeigt ein Ausführungsbeispiel für eine Verbindungsanordnung, bei der ein Halbleiter mit einem Substrat stoffschlüssig verbunden ist und ein Anschluss des Halbleiters mittels eines durch ein Metallband gebildeten Bonddrahtes mit dem Substrat verbunden ist, wobei das Metallband zwei Metallschichten, oder in einer anderen Ausführungsform drei Metallschichten aufweist.

Figur 1 zeigt ein Ausführungsbeispiel für eine Verbindungsanordnung 1. Die Verbindungsanordnung 1 weist ein Substrat 2 auf. Das Substrat 2 weist in diesem Ausführungsbeispiel eine elektrisch leitfähige Schicht 3 und eine elektrisch leitfähige Schicht 4 auf. Die elektrisch leitfähigen Schichten 3 und 4 sind in diesem Ausführungsbeispiel durch einen Lead-Frame gebildet. Die elektrisch leitfähigen Schichten 3 und 4 sind beispielsweise durch ein formgestanzes Kupferblech gebildet.

Die Verbindungsanordnung 1 weist auch einen Halbleiter 6, in diesem Ausführungsbeispiel einen als Bare-Die ausgebildeten gehäuselosen Halbleiterschalter, insbesondere Feldeffekttransistor, auf. Der Halbleiter 6 weist einen elektrischen Anschluss 7 und einen elektrischen Anschluss 8 auf. Die elektrischen Anschlüsse 7 und 8 bilden jeweils einen Schaltstreckenanschluss einer Schaltstrecke des Halbleiters 6. Die Anschlüsse 7 und 8 sind jeweils durch eine Metallschicht, in diesem Ausführungsbeispiel eine Aluminiumschicht, gebildet. Der Anschluss 7 ist mittels eines Lotmittels 9 mit der elektrisch leitfähigen Schicht 4 elektrisch und stoffschlüssig verbunden. Der Anschluss 8 ist mittels der elektrisch leitfähigen Schicht 3 mittels eines Metallbandes 10 elektrisch leitfähig verbunden.

Das Metallband 10 weist einen Endabschnitt 14 auf, welcher mit dem Anschluss 8 mittels Ultraschallschweißen, insbesondere Bonden, verbunden ist und einen Endabschnitt 15, welcher mittels Ultraschallschweißen, insbesondere Bonden, mit der elektrisch leitfähigen Schicht 3 verbunden ist.

Das Metallband 10 weist in diesem Ausführungsbeispiel zwei Metallschichten, nämlich eine Metallschicht 11 und eine Metallschicht 12 auf. Die Metallschicht 11 weist eine kleinere elektrische Leitfähigkeit auf als die Metallschicht 12. Eine Dickenerstreckung 16 der Metallschicht 12 beträgt in diesem Ausführungsbeispiel das Doppelte einer Dickenerstreckung 17 der Metallschicht 11, welche mit dem Anschluss 8 des Halbleiters 6 verbunden ist.

Der Halbleiter 6 und das Metallband 10 sind gemeinsam mit einem Teil der elektrisch leitfähigen Schichten 3 und 4 in eine Moldmasse 18 eingebettet. Die Moldmasse 18 ist beispielsweise durch eine Kunststoffmasse gebildet. Die Moldmasse 18 weist in diesem Ausführungsbeispiel Füllpartikel 19, insbesondere Keramikpartikel, auf. Die Keramikpartikel sind beispielsweise Aluminiumoxidpartikel, Bornitridpartikel oder Siliziumnitridpartikel. Mit dem Dickenverhältnis zwischen der weiteren Metallschicht 12 und der Metallschicht 11, von 2:1, wird vorteilhaft bewirkt, dass es zwischen der weiteren Metallschicht 12 und der Moldmasse 18 nicht zu Ablöseerscheinungen kommen kann.

Figur 1 zeigt auch - gestrichelt dargestellt - eine Variante des Substrates 2, bei der das Substrat eine elektrisch isolierende Keramikschicht (5) aufweist. Das Substrat 2 ist in der Variante beispielsweise durch ein DCB-Substrat oder ein AMB-Substrat gebildet.

Figur 1 zeigt auch eine Variante der bereits beschriebenen Verbindungsanordnung 1, bei der das Metallband 10 - gestrichelt dargestellt - zusätzlich zu den bisher beschriebenen zwei Metallschichten, nämlich den Metallschichten 11 und 12, eine weitere, dritte Metallschicht 13 aufweist. Die weitere Metallschicht 13 bildet in diesem Ausführungsbeispiel eine äußere Metallschicht und ist mit der weiteren Metallschicht 12 verbunden. Die äußere Metallschicht 13 und die Metallschicht 11, welche mit dem Anschluss 8 des Halbleiters 6 verbunden ist, schließen so gemeinsam die weitere Metallschicht 12, nämlich die Kupferschicht, zwischeneinander ein. Die äußere Metallschicht 13 weist in diesem Ausführungsbeispiel eine Dickenerstreckung auf, welche der Dickenerstreckung 17 der mit dem Anschluss 8 des Halbleiters 6 verbundenen Metallschicht 11 entspricht. Die äußere Metallschicht 13 ist in diesem Ausführungsbeispiel durch eine Aluminiumschicht gebildet. Die Metallschicht 13 kann in einer anderen Ausführungsform durch eine Silberschicht gebildet sein.

In einer anderen Ausführungsform ist die äußere Metallschicht 13 durch eine magnesiumhaltige Schicht oder eine Magnesiumschicht gebildet. Die magnesiumhaltige Schicht ist beispielsweise eine Magnesiumlegierung, insbesondere Elektron. Durch die Elektron-Schicht wird vorteilhaft eine hohe mechanische Festigkeit des Metallbandes bewirkt. Die magnesiumhaltige Schicht weist bevorzugt Magnesium als Hauptbestandteil und als weiteren Bestandteil Aluminium auf. Weiter bevorzugt beträgt ein Anteil des Magnesiums in der magnesiumhaltigen äußeren Metallschicht 90 Gewichts-Prozent und ein Anteil des Aluminiums bis zu 10 oder 10 Gewichts-Prozent. Weitere Bestandteile können Zink und/oder Zirkonium sein.

## Patentansprüche

1. Verbindungsanordnung (1) umfassend einen Halbleiter (6), ein Substrat (2) und wenigstens ein Metallband (10), wobei ein elektrischer Anschluss (8) des Halbleiters (6) mittels eines Metallbandes (10) mit einem Substrat (2) ultraschallverschweißt ist,
wobei das Metallband (10) wenigstens zwei Metallschichten (11, 12) aus zueinander verschiedenen Metallen aufweist,
**dadurch gekennzeichnet, dass**
eine Dickenerstreckung (17) der mit dem Anschluss (8) verbundenen Metallschicht (11) des Metallbandes (10) die Hälfte einer Dickenerstreckung (16) der mit der Metallschicht (11) verbundenen weiteren Metallschicht (12) der Metallschichten (11, 12) beträgt.

2. Verbindungsanordnung (1) nach Anspruch 1,
**dadurch gekennzeichnet, dass**
das Metallband (10) drei miteinander verbundene Metallschichten (11, 12, 13) aufweist, und die weitere Metallschicht (12) zwischen der mit dem Anschluss 8) verbundenen Metallschicht (11) und der äußeren Metallschicht (13) eingeschlossen ist.

3. Verbindungsanordnung (1) nach Anspruch 2,
**dadurch gekennzeichnet, dass**
die äußere Metallschicht (13) dieselbe Dickenerstreckung (17) aufweist wie die mit dem Anschluss (8) verbundene Metallschicht (11).

4. Verbindungsanordnung (1) nach einem der vorhergehenden Ansprüche 2 oder 3,
**dadurch gekennzeichnet, dass**
die äußere Metallschicht (13) aus demselben Material oder einer aus einem Material mit demselben oder einem ähnlichen Wärmeausdehnungskoeffizienten gebildet, wie die mit dem Anschluss (8) verschweißte Metallschicht (11).

5. Verbindungsanordnung (1) nach einem der vorhergehenden Ansprüche,
**dadurch gekennzeichnet, dass**
die weitere Metallschicht (12) aus einem Metall mit einer größeren elektrischen Leitfähigkeit als die Leitfähigkeit der Metallschicht (11) gebildet ist.

6. Verbindungsanordnung (1) nach einem der vorhergehenden Ansprüche,
**dadurch gekennzeichnet, dass**
die mit dem Halbleiter (6) verbundene Metallschicht (8) eine Aluminium haltige Schicht oder Aluminiumschicht ist.

7. Verbindungsanordnung (1) nach einem der vorhergehenden Ansprüche,
**dadurch gekennzeichnet, dass**
die weitere Metallschicht (12) eine Kupfer haltige Schicht oder eine Kupferschicht ist.

8. Verbindungsanordnung (1) nach einem der vorhergehenden Ansprüche 2 bis 7,
**dadurch gekennzeichnet, dass**
die äußere Metallschicht (13) Aluminium und/oder Magnesium aufweist.

9. Verbindungsanordnung (1) nach Anspruch 8,
**dadurch gekennzeichnet, dass**
die äußere Metallschicht (13) durch eine magnesiumhaltige Schicht gebildet ist, welche Magnesium als Hauptbestandteil und als weiteren Bestandteil Aluminium aufweist.

10. Verbindungsanordnung (1) nach Anspruch 9,
**dadurch gekennzeichnet, dass**
ein Anteil des Magnesiums in der magnesiumhaltigen äußeren Metallschicht (13) 90 Gewichts-Prozent und ein Anteil des Aluminiums bis zu 10 oder 10 Gewichts-Prozent beträgt.

11. Verbindungsanordnung (1) nach einem der vorhergehenden Ansprüche 2 bis 7,
**dadurch gekennzeichnet, dass**
die äußere Metallschicht (13) eine Silberschicht ist.

12. Verbindungsanordnung (1) nach einem der vorhergehenden Ansprüche,
**dadurch gekennzeichnet, dass**
der Halbleiter (6) und das Metallband (10) in eine Moldmasse (18) eingebettet sind.

13. Verbindungsanordnung (1) nach einem der vorhergehenden Ansprüche,
**dadurch gekennzeichnet, dass**
der Halbleiter (6) ein Feldeffekttransistor ist.

14. Verbindungsanordnung (1) nach einem der vorhergehenden Ansprüche,
**dadurch gekennzeichnet, dass**
das Substrat (2) ein Blechstück, insbesondere Lead-Frame ist.

15. Verbindungsanordnung (1) nach einem der vorhergehenden Ansprüche,
**dadurch gekennzeichnet, dass**
das Substrat (2) ein keramisches Substrat umfassend wenigstens eine elektrisch isolierende Keramikschicht (5) und wenigstens eine elektrisch leitfähige Schicht (3, 4) ist.

## Claims

1. Connection assembly (1) comprising a semiconductor (6), a substrate (2), and at least one metal strip (10), wherein an electrical connector (8) of the semiconductor (6) by means of a metal strip (10) is ultrasonically welded to a substrate (2), wherein the metal strip (10) has at least two metal layers (11, 12) of mutually dissimilar metals,
**characterized in that**
a thickness extent (17) of the metal layer (11) of the metal strip (10) that is connected to the connector (8) is half a thickness extent (16) of the further metal layer (12) of the metal layers (11, 12) that is connected to the metal layer (11).

2. Connection assembly (1) according to Claim 1,
**characterized in that**
the metal strip (10) has three interconnected metal layers (11, 12, 13), and the further metal layer (12) is enclosed between the metal layer (11) that is connected to the connector (8) and the external metal layer (13).

3. Connection assembly (1) according to Claim 2,
**characterized in that**
the external metal layer (13) has the same thickness extent (17) as the metal layer (11) that is connected to the connector (8).

4. Connection assembly (1) according to one of preceding Claims 2 or 3,
**characterized in that**
the external metal layer (13) is formed from the same material or from a material having the same or a similar coefficient of thermal expansion as the metal layer (11) that is welded to the connector (8).

5. Connection assembly (1) according to one of the preceding claims,
**characterized in that**
the further metal layer (12) is formed from a metal having an electrical conductivity that is higher than the conductivity of the metal layer (11).

6. Connection assembly (1) according to one of the preceding claims,
**characterized in that**
the metal layer (8) that is connected to the semiconductor (6) is an aluminium-containing layer or an aluminium layer.

7. Connection assembly (1) according to one of the preceding claims,
**characterized in that**
the further metal layer (12) is a copper-containing layer or a copper layer.

8. Connection assembly (1) according to one of preceding Claims 2 to 7,
**characterized in that**
the external metal layer (13) comprises aluminium and/or magnesium.

9. Connection assembly (1) according to Claim 8,
**characterized in that**
the external metal layer (13) is formed by a magnesium-containing layer which comprises magnesium as the main component and aluminium as a further component.

10. Connection assembly (1) according to Claim 9,
**characterized in that**
a proportion of the magnesium in the magnesium-containing external metal layer (13) is 90% by weight, and a proportion of the aluminium is up to 10 or 10% by weight.

11. Connection assembly (1) according to one of preceding Claims 2 to 7,
**characterized in that**
the external metal layer (13) is a silver layer.

12. Connection assembly (1) according to one of the preceding claims,
**characterized in that**
the semiconductor (6) and the metal strip (10) are embedded in a moulding compound (18).

13. Connection assembly (1) according to one of the preceding claims,
**characterized in that**
the semiconductor (6) is a field effect transistor.

14. Connection assembly (1) according to one of the preceding claims,
**characterized in that**
the substrate (2) is a piece of sheet metal, in particular a lead frame.

15. Connection assembly (1) according to one of the preceding claims,
**characterized in that**
the substrate (2) is a ceramics substrate comprising at least one electrically isolating ceramics layer (5) and at least one electrically conductive layer (3, 4).

## Revendications

1. Dispositif de raccordement (1), comprenant un semi-conducteur (6), un substrat (2) et au moins une bande métallique (10), une connexion (8) électrique du semi-conducteur (6) étant assemblée par soudage par ultrasons à un substrat (2) au moyen d'une bande métallique (10),
la bande métallique (10) présentant au moins deux couches métalliques (11, 12) composées de métaux différents l'un de l'autre,
**caractérisé en ce**
**qu'**une étendue en épaisseur (17) de la couche métallique (11) de la bande métallique (10) raccordée à la connexion électrique (8) est égale à la moitié d'une étendue en épaisseur (16) de l'autre couche métallique (12) des couches métalliques (11, 12) raccordée à la couche métallique (11).

2. Dispositif de raccordement (1) selon la revendication 1,
**caractérisé en ce que**
la bande métallique (10) présente trois couches métalliques (11, 12, 13) raccordées les unes aux autres, et l'autre couche métallique (12) est englobée entre la couche métallique (11) raccordée à la connexion (8) et la couche métallique (13) extérieure.

3. Dispositif de raccordement (1) selon la revendication 2,
**caractérisé en ce que**
la couche métallique (13) extérieure présente la même étendue en épaisseur (17) que la couche métallique (11) raccordée à la connexion (8).

4. Dispositif de raccordement (1) selon l'une des revendications précédentes 2 ou 3,
**caractérisé en ce que**
la couche métallique (13) extérieure est formée du même matériau, ou d'un matériau ayant un coefficient de dilatation thermique identique ou semblable, que la couche métallique (11) assemblée par soudage à la connexion électrique (8).

5. Dispositif de raccordement (1) selon l'une des revendications précédentes,
**caractérisé en ce que**
l'autre couche métallique (12) est formée d'un métal ayant une conductibilité électrique plus élevée que la conductibilité électrique de la couche métallique (11).

6. Dispositif de raccordement (1) selon l'une des revendications précédentes,
**caractérisé en ce que**
la couche métallique (8) raccordée au semi-conducteur (6) est une couche contenant de l'aluminium ou une couche d'aluminium.

7. Dispositif de raccordement (1) selon l'une des revendications précédentes,
**caractérisé en ce que**
l'autre couche métallique (12) est une couche contenant du cuivre ou une couche de cuivre.

8. Dispositif de raccordement (1) selon l'une des revendications précédentes 2 à 7,
**caractérisé en ce que**
la couche métallique (13) extérieure présente de l'aluminium et/ou du magnésium.

9. Dispositif de raccordement (1) selon la revendication 8,
**caractérisé en ce que**
la couche métallique (13) extérieure est formée d'une couche contenant du magnésium, lequel magnésium présente de l'aluminium en tant que composant principal ou en tant que composant supplémentaire.

10. Dispositif de raccordement (1) selon la revendication 9,
**caractérisé en ce que**
la proportion de magnésium dans la couche métallique (13) extérieure contenant du magnésium est égale à 90 pour cent-poids et une proportion de l'aluminium représente jusqu'à 10 ou est égale à 10 pour cent-poids.

11. Dispositif de raccordement (1) selon l'une des revendications précédentes 2 à 7,
**caractérisé en ce que**
la couche métallique (13) extérieure est une couche d'argent.

12. Dispositif de raccordement (1) selon l'une des revendications précédentes,
**caractérisé en ce que**
le semi-conducteur (6) et la bande métallique (10) sont noyés dans une masse moulée (18).

13. Dispositif de raccordement (1) selon l'une des revendications précédentes,
**caractérisé en ce que**
le semi-conducteur (6) est un transistor à effet de champ.

14. Dispositif de raccordement (1) selon l'une des revendications précédentes,
**caractérisé en ce que**
le substrat (2) est une pièce en tôle, en particulier un leadframe.

15. Dispositif de raccordement (1) selon l'une des revendications précédentes,
**caractérisé en ce que**
le substrat (2) est un substrat céramique comprenant au moins une couche céramique (5) électriquement isolante et au moins une couche (3, 4) électriquement conductrice.
